# EUROPEAN PATENT SPECIFICATION

(11) **EP 1 793 658 B1**
(45) Date of publication and mention of the grant of the patent: **15.06.2011**
(21) Application number: 04799462.9
(22) Date of filing: 02.11.2004
(51) Int. Cl.: H05K 1/11, H05K 3/34, H05K 1/02

(54) **WIRING BOARD AND WIRING BOARD MODULE**
LEITERPLATTE UND LEITERPLATTENMODUL
CARTE DE CABLAGE ET MODULE DE CARTE DE CABLAGE

(30) Priority: 22.09.2004 JP 2004275881
(43) Date of publication of application: 06.06.2007
(73) Proprietor: MURATA MANUFACTURING CO., LTD., Nagaokakyo-shi, Kyoto 617-8555 (JP)
(72) Inventor: Fujikawa, Katsuhiko, c/o (A170) Intellectual Property Department, Nagaokakyo-shi, Kyoto 6178555 (JP); Tanaka, Koji, c/o (A170)Intellectual Property Department, Nagaokakyo-shi Kyoto 6178555 (JP)
(74) Representative: Schoppe, Fritz
(86) International application number: PCT/JP2004/016259
(87) International publication number: WO 2006/033170

(56) References cited:
- EP-A- 1 255 300
- JP-A- 3 077 394
- JP-A- 6 260 746
- JP-A- 9 307 022
- JP-A- 2003 060 334
- JP-A- 2004 172 260
- JP-U- 1 112 076
- JP-U- 3 061 373
- US-A1- 2002 125 043
- US-B1- 6 217 990

## Description

### Technical Field

The present invention relates to a wiring board, more specifically, it relates to a wiring board on which electronic components such as an IC are to be mounted and a wiring board module.

### Background Art

There has been known a high-frequency module in which various components, such as an IC component, a crystal oscillator, and other surface mount components, are mounted on the mounting surface of a ceramic wiring board (see, for example, Patent Document 1). On the mounting surface of this wiring board are formed various mounting lands. Normally, one mounting land is formed for each external terminal of the mounted components. In general, the sizes of these mounting lands are designed according to the sizes of external terminals of the mounted components. The reason is that mounting a large-size component requires a large amount of solder and therefore requires large-area lands.

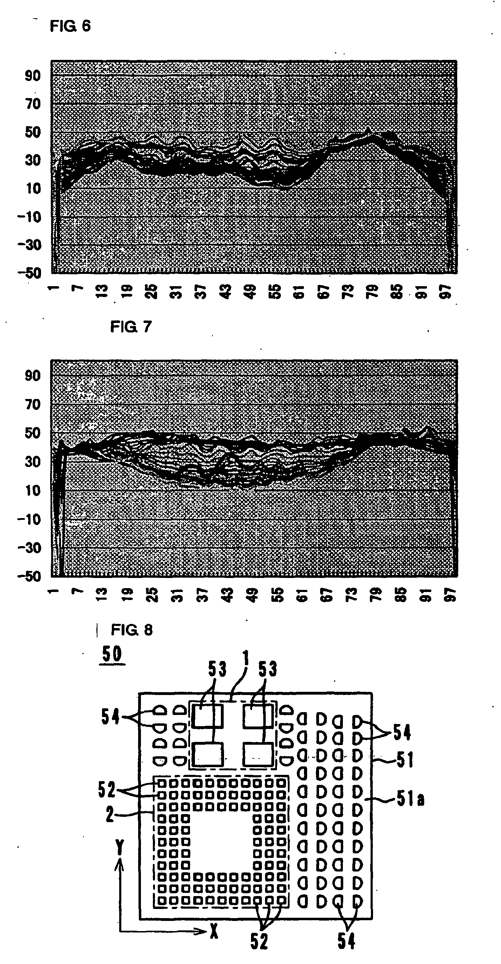

FIG. 8 is a plan view showing an example of a conventional ceramic wiring board module 50. On the mounting surface 51a of a wiring board 51 are mounted a crystal oscillator 1 and an IC component 2, which are shown by an alternate long and short dash line, and other surface mount components (not shown). On the mounting surface 51a are formed mounting lands 52 for the IC component 2, mounting lands 53 for the crystal oscillator 1, and mounting lands 54 for other surface mount components. The area of the mounting lands 53 is remarkably large compared to the other mounting lands 52 and 54.

However, when the large-area mounting lands 53 are disposed, large local swells (protrusions) are generated at the positions of the mounting lands 53 on the mounting surface 51a of the wiring board 51. This is due to the difference in shrinkage factor between the wiring board body and the mounting lands upon firing. In general, upon firing, while a board body formed of ceramic shrinks, mounting lands hardly shrink. Therefore, when large-area mounting lands are disposed, the mounting surface of the wiring board swells.

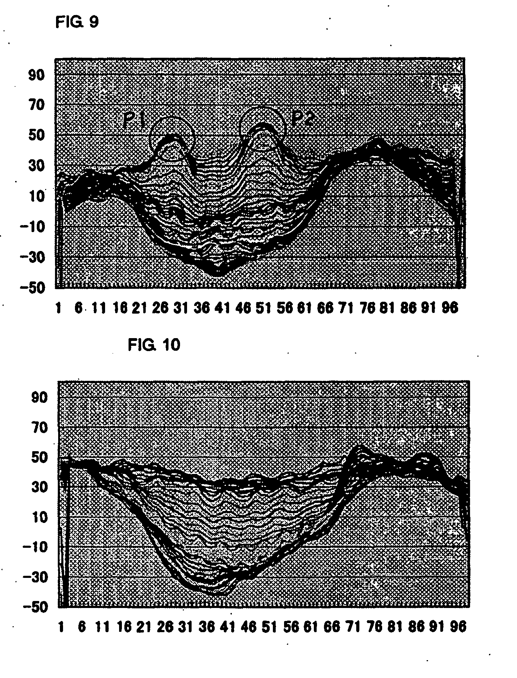

FIG. 9 is a graph showing the amount of swell in the X direction in the conventional wiring board 51 measured throughout the wiring board 51 at predetermined pitch intervals. FIG. 10 is a graph showing the amount of swell in the Y direction in the conventional wiring board 51 measured throughout the wiring board 51 at predetermined pitch intervals. In FIGS. 9 and 10, the vertical axis indicates the amount of swell (µm), and the horizontal axis indicates the positions of measuring points.

In the circles P1 and P2 in FIG. 9, large local swells due to the mounting lands 53 are generated. These swells prevent small-size electronic components from being mounted in place or prevent electronic components from being mounted horizontally. Patent Document 1: Japanese Unexamined Patent Application Publication No. 2002-9225

US 2002/125043 A1 discloses a semiconductor device mounted on a board by providing on the board connecting pads each split into at least two parts corresponding to one external electrode formed on the semiconductor device, and connecting each of the external electrodes to respective parts of the connecting pad split into at least two parts via a solder bump. Further, the split parts of the connecting pad are connected respectively to separate external terminals via internal wirings provided within the board.; The connecting conditions of the packaging structure of the semiconductor device in which the external electrodes are connected to the connecting pads via solder bumps is confirmed by inspecting the electric continuity conditions between the parts of the connecting pads each split into at least two parts or the electrical continuity conditions between the external terminals connected to the split parts of the connecting pads.; Moreover, the external terminals are provided on the peripheral portion of the board, a separation assisting structure is provided between the peripheral portion of the surface of the board where the external terminals are provided and the portion of the surface of the board where the connecting pads are formed, and the peripheral portion of the board is deleted after the inspection of the electrical continuity conditions between the external terminals is completed.

US-B1-6217990 discloses a multilayer circuit board for holding a flip chip thereon. The circuit board includes laminated first to fourth substrates. A first pattern integrated portion having a locally high pattern density is provided on the second substrate. Further, on the fourth substrate which is disposed on an opposite side of the second substrate with respect to a center in a laminated direction of the circuit board, a second pattern integrated portion having a locally high pattern density is disposed to correspond to the first pattern integrated portion. Accordingly, a local warp can be prevented from being produced on the mounting surface of the multilayer circuit board when the circuit board is manufactured by baking.

EP-A-1255300 discloses a semiconductor package provided with an interconnection layer including an interconnection pattern and pad formed on an insulating substrate or insulating layer, a protective layer covering the interconnection layer except at the portion of the pad and the insulating substrate or insulating layer, and an external connection terminal bonded with the pad exposed from the protective layer, the pad to which the external connection terminal is bonded being comprised of a plurality of pad segments, sufficient space being opened for passing an interconnection between pad segments, and the pad segments being comprised of at least one pad segment connected to an interconnection and other pad segments not connected to interconnections.

An object of the present invention is to provide a wiring board and a wiring board module in which the swell of the board body can be reduced.

This object is achieved by a wiring board according to claim 1.

The board body has a single ceramic board structure or a multilayer structure in which a plurality of ceramic layers and a plurality of internal electrodes are laminated.

In aspects of the present invention, a relatively large-area mounting land is composed of relatively small-area land pieces. Therefore, the difference in shrinkage factor between the wiring board and the mounting lands upon firing is less concentrated locally. On the other hand, since relatively small-area land pieces form a substantially large-area land, a sufficient amount of solder can be supplied even to a large-size mounted component.

In aspects of the present invention, at least one of the plurality of land pieces that are to be electrically connected via a terminal of one of the components to be mounted preferably has an area no more than half of the projected area of the terminal on the mounting surface of the board body. In this case, the area of the land pieces is not unnecessarily large and is set to an appropriate area.

The area ratio A/a between the largest area A and the smallest area a of the areas of the land pieces and the areas of the mounting lands except for the mounting lands composed of a plurality of land pieces, is 3 or less. In this case, the amount of the swell (the amount of the protrusion) on the mounting surface due to the difference in shrinkage factor between the board body and the mounting lands can be evened out, and the difference in height between the mounting lands can be reduced.

A swell correcting pattern may be provided in a region on the surface of the board body where no mounting lands are formed. By intentionally generating swells (protrusions) with the swell correcting pattern so that the amount of swell is the same as that in the region where the mounting lands are formed, the mounting surface is made flatter.

In another aspect of the present invention, a wiring board module includes a wiring board having the above-described characteristics, and a component mounted on the wiring board so that a terminal of the component electrically connects the plurality of land pieces.

### Advantages

In the present invention, a relatively large-area mounting land is composed of relatively small-area land pieces. Therefore, the difference in shrinkage factor between the wiring board and the mounting lands upon firing is less concentrated locally. Thus, the large local swells generated on the mounting surface of the wiring board can be reduced. On the other hand, since relatively small-area land pieces form a substantially large-area land, a sufficient amount of solder can be supplied even to a large-size mounted component.

### Brief Description of the Drawings

FIG. 1 is a plan view showing a first embodiment of the wiring board and the wiring board module according to the present invention.
FIG. 2 is a sectional view illustrating a mounting state of the wiring board module shown in FIG. 1.
FIG. 3 is a graph showing the amount of swell in the X direction in the wiring board shown in FIG. 1.
FIG. 4 is a graph showing the amount of swell in the Y direction in the wiring board shown in FIG. 1.
FIG. 5 is a plan view showing a second embodiment of the wiring board and the wiring board module according to the present invention.
FIG. 6 is a graph showing the amount of swell in the X direction in the wiring board shown in FIG. 5.
FIG. 7 is a graph showing the amount of swell in the Y direction in the wiring board shown in FIG. 5
FIG. 8 is a plan view showing a conventional wiring board and a conventional wiring board module.
FIG. 9 is a graph showing the amount of swell in the X direction in the wiring board shown in FIG. 8.
FIG. 10 is a graph showing the amount of swell in the Y direction in the wiring board shown in FIG. 8.

### Best Mode for Carrying Out the Invention

Embodiments of the wiring board and the wiring board module according to the present invention will now be described with reference to the drawings.

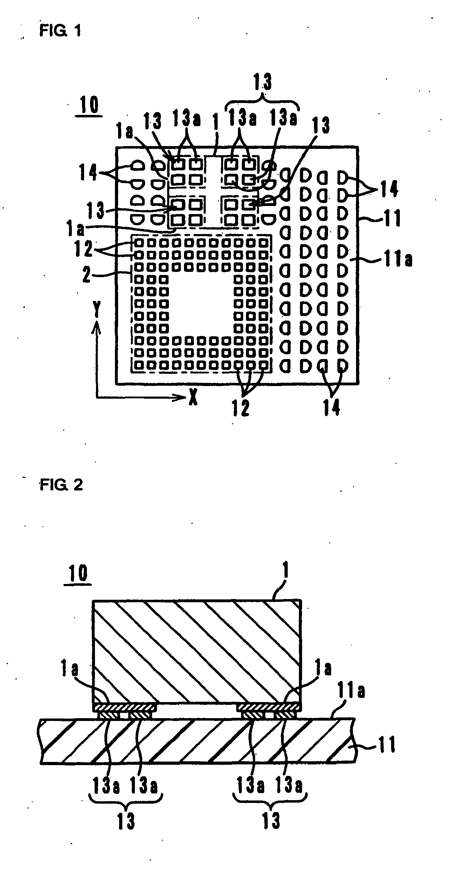

### (First Embodiment, FIGS. 1 to 4)

As shown in FIG. 1, a wiring board module 10 includes a multilayer wiring board 11. On the mounting surface 11a of the multilayer wiring board 11 are mounted a crystal oscillator 1 and an IC component 2, which are shown by an alternate long and short dash line, and other surface mount components (not shown). On the mounting surface 11a are formed mounting lands 12 for the IC component 2, mounting lands 13 for the crystal oscillator 1, and mounting lands 14 for other surface mount components.

Each mounting land 13 for the crystal oscillator 1 is not a conventional single large-area land shown in FIG. 8 but is composed of four adjacent land pieces 13a. The four land pieces 13a are electrically connected via an external terminal 1a of the crystal oscillator 1, thereby functioning as a mounting land for the external terminal 1a. In other words, each of the plurality of mounting lands 13 provided at positions corresponding to external terminals 1a of the crystal oscillator 1 is divided into four land pieces 13a.

The multilayer wiring board 11 is made by stacking, press-bonding, and then co-firing a ceramic green sheet on which mounting lands 12 to 14 are provided, a ceramic green sheet on which internal electrodes are provided, and the like. The mounting lands 12 to 14 and the internal electrodes are formed of silver, palladium, copper, gold, and their alloys by screen printing.

The crystal oscillator 1, the IC component 2, and other surface mount components are soldered onto the surface of this multilayer wiring board 11. As shown in FIG. 2, each external terminal 1a of the crystal oscillator 1 is soldered to four land pieces 13a of the corresponding mounting land 13. Therefore, the four land pieces 13a are electrically connected to each other by the external terminal 1a of the crystal oscillator 1.

Since the relatively large-area mounting land 13 is composed of the relatively small-area land pieces 13a, the difference in shrinkage factor between the multilayer wiring board 11 and the mounting lands 13 upon firing is less concentrated locally. Thus, the large local swells (mainly protrusions) generated on the mounting surface 11a of the multilayer wiring board 11 can be reduced. Consequently, the defective mounting of the components 1 and 2 can be reduced. On the other hand, since relatively small-area land pieces 13a form a substantially large-area land 13, a sufficient amount of solder can be supplied even to the large-size crystal oscillator 1.

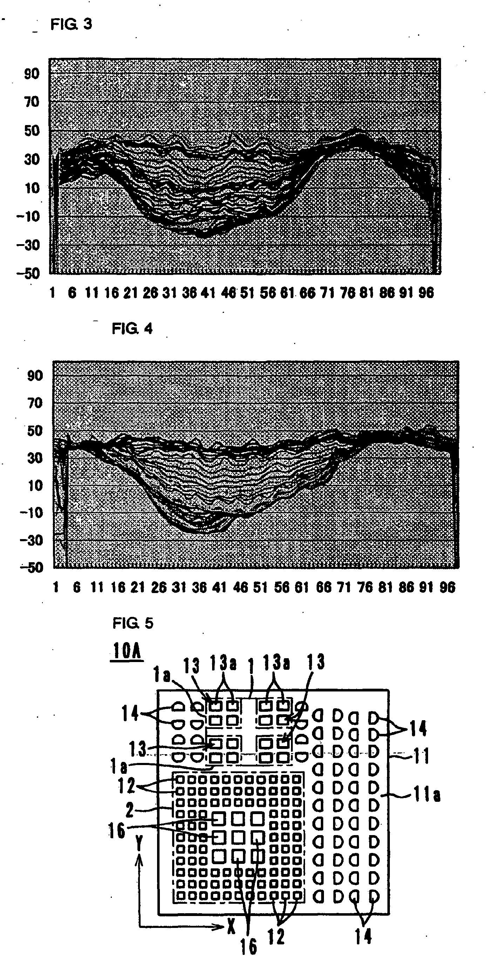

FIG. 3 is a graph showing the amount of swell in the X direction in the multilayer wiring board 11 shown in FIG. 1, measured throughout the multilayer wiring board 11 at predetermined pitch intervals. FIG. 4 is a graph showing the amount of swell in the Y direction in the multilayer wiring board 11, measured throughout the multilayer wiring board 11 at predetermined pitch intervals. In FIGS. 3 and 4, the vertical axis indicates the amount of swell (µm), and the horizontal axis indicates the positions of measuring points.

As is clear from the comparison of FIGS. 3 and 9, no large local swells (protrusions) are generated in the multilayer wiring board 11, unlike in the conventional wiring board 51.

The four land pieces 13a that are to be electrically connected via an external terminal 1a of the crystal oscillator 1 have an area no more than half of the projected area of the external terminal 1a on the mounting surface 11a of the board body. In the case of the first embodiment, the area is set to 1/4 or less. Therefore, the area of the land pieces 13a is not unnecessarily large and is set to an appropriate area.

Of the areas of the land pieces 13a and the mounting lands 12 and 14 except for the mounting lands 13 composed of a plurality of land pieces 13a, the largest area A is that of the land pieces 13a, and the smallest area a is that of the mounting lands 12. The area ratio A/a therebetween is preferably 3 or less. In this case, the area of the land pieces 13a and the areas of the mounting lands 12 and 14 can be prevented from differing widely. The amount of the swell (the amount of the protrusion) on the mounting surface due to the difference in shrinkage factor between the multilayer wiring board 11 and the mounting lands 12 to 14 can be evened out, and the difference in height between the mounting lands can be further reduced.

### (Second Embodiment, FIGS. 5 to 7)

In the wiring board module 10A of a second embodiment, as shown in FIG. 5, the multilayer wiring board 11 has a swell correcting pattern 16 provided in an empty region in the portion where the IC component 2 is to be mounted (a region in which no mounting lands 12 are formed and which is surrounded by the mounting lands 12). The swell correcting pattern 16 is not a single large-area pattern but a plurality of relatively small-area patterns disposed close to each other.

As described above, in general, upon firing, while a board body formed of ceramic shrinks, mounting lands hardly shrink. Therefore, the portions where the mounting lands are disposed on the mounting surface swell. Therefore, the portion where no mounting lands 12 are disposed is relatively depressed. The swell correcting pattern 16 is therefore provided in the region on the surface of the multilayer wiring board 11 where no mounting lands 12 are formed. By intentionally generating swells (protrusions) with the swell correcting pattern 16 so that the amount of swell is the same as that in the region where the mounting lands 12 are formed, the mounting surface can be made flatter.

FIG. 6 is a graph showing the amount of swell in the X direction in the multilayer wiring board 11 shown in FIG. 5, measured throughout the multilayer wiring board 11 at predetermined pitch intervals. FIG. 7 is a graph showing the amount of swell in the Y direction in the multilayer wiring board 11, measured throughout the multilayer wiring board 11 at predetermined pitch intervals. In FIGS. 6 and 7, the vertical axis indicates the amount of swell (µm), and the horizontal axis indicates the positions of measuring points.

FIGS. 6 and 7 show that the multilayer wiring board 11 of the second embodiment has less swell compared to the first embodiment.

### (Other Embodiments)

The present invention is not limited to the above-described embodiments, and various changes may be made without departing from the scope of the invention. The wiring board is not limited to a multilayer board but may be a single ceramic board.

### Industrial Applicability

As described above, the present invention is useful for high-frequency modules on which electronic components such as an IC are mounted, and is excellent particularly in terms of reduction in swell of the substrate body.

## Claims

1. A wiring board (11) comprising:
a board body on which components are to be mounted; and
a plurality of mounting lands (12,13,14) formed on the board body, wherein at least one of the mounting lands (13) has an area larger than the area of at least one other mounting land (12) and is composed of a plurality of adjacent land pieces (13a) that are to be electrically connected via a terminal (1a) of one of the components (1) to be mounted and that are to thereby function as a mounting land for the terminal (1a),
**characterized in that** the area ratio A/a between the largest area A and the smallest area a of the areas of the land pieces (13a) and the mounting lands (12, 14) except for the mounting lands (13) composed of a plurality of land pieces (13a), is 3 or less.

2. A wiring board (11) according to claim 1, wherein the plurality of mounting lands (12,13,14) is provided at positions corresponding to terminals (1a) of the components (1) to be mounted.

3. The wiring board (11) according to Claim 1 or 2, wherein at least one of the plurality of land pieces (13a) that are to be electrically connected via a terminal (1a) of one of the components (1) to be mounted has an area no more than half of the projected area of the terminal (1a) on the mounting surface (11a) of the board body.

4. The wiring board (11) according to Claim 1 or 2, wherein every one of the plurality of land pieces (13a) that are to be electrically connected via a terminal (1a) of one of the components (1) to be mounted has an area no more than half of the projected area of the terminal (1) on the mounting surface of the board body.

5. The wiring board (11) according to Claim 1 or 2, wherein a swell correcting pattern (16) is provided in a region on the surface of the board body where no mounting lands (12, 13, 14) are formed.

6. The wiring board (11) according to Claim 1 or 2, wherein the board body is formed of ceramic.

7. The wiring board (11) according to Claim 1 or 2, wherein the board body has a multilayer structure in which a plurality of ceramic layers and a plurality of internal electrodes are laminated.

8. A wiring board module comprising:
the wiring board (11) according to Claim 1 or 2; and
a component (1) mounted on the wiring board (11) so that a terminal (1a) of the component (1) electrically connects the plurality of land pieces (13a).

## Patentansprüche

1. Eine Verdrahtungsplatine (11), die folgende Merkmale aufweist:
einen Platinenkörper, auf dem Komponenten anzubringen sind; und
eine Mehrzahl von Anbringungs-Kontaktstellen (12, 13, 14), die auf dem Platinenkörper gebildet sind, wobei zumindest eine der Anbringungs-Kontaktstellen (13) eine Fläche aufweist, die größer als die Fläche zumindest einer anderen Anbringungs-Kontaktstelle (12) ist, und aus einer Mehrzahl von benachbarten Kontaktstellenstücken (13a) zusammengesetzt ist, die über einen Anschluss (1a) einer der anzubringenden Komponenten elektrisch zu verbinden sind und die dadurch als eine Anbringungs-Kontaktstelle für den Anschluss (1a) fungieren sollen,
**dadurch gekennzeichnet, dass** das Flächenverhältnis A/a zwischen der größten Fläche A und der kleinsten Fläche a der Flächen der Kontaktstellenstücke (13a) und der Anbringungs-Kontaktstellen (12, 14) mit Ausnahme der Anbringungs-Kontaktstellen (13), die aus einer Mehrzahl von Kontaktstellenstücken (13a) zusammengesetzt sind, 3 oder weniger beträgt.

2. Eine Verdrahtungsplatine (11) gemäß Anspruch 1, bei der die Mehrzahl von Anbringungs-Kontaktstellen (12, 13, 14) an Positionen bereitgestellt ist, die Anschlüssen (1a) der anzubringenden Komponenten (1) entsprechen.

3. Die Verdrahtungsplatine (11) gemäß Anspruch 1 oder 2, bei der zumindest eines der Mehrzahl von Kontaktstellenstücken (13a), die über einen Anschluss (1a) einer der anzubringenden Komponenten (1) elektrisch zu verbinden sind, eine Fläche von nicht mehr als der Hälfte der vorstehenden Fläche des Anschlusses (1a) auf der Anbringungsoberfläche (11a) des Platinenkörpers aufweist.

4. Die Verdrahtungsplatine (11) gemäß Anspruch 1 oder 2, bei der jedes der Mehrzahl von Kontaktstellenstücken (13a), die über einen Anschluss (1a) einer der anzubringenden Komponenten (1) elektrisch zu verbinden sind, eine Fläche von nicht mehr als der Hälfte der vorstehenden Fläche des Anschlusses (1) auf der Anbringungsoberfläche des Platinenkörpers aufweist.

5. Die Verdrahtungsplatine (11) gemäß Anspruch 1 oder 2, bei der eine Wölbungskorrekturstruktur (16) in einer Region auf der Oberfläche des Platinenkörpers vorgesehen ist, wo keine Anbringungs-Kontaktstellen (12, 13, 14) gebildet sind.

6. Die Verdrahtungsplatine (11) gemäß Anspruch 1 oder 2, bei der der Platinenkörper aus Keramik gebildet ist.

7. Die Verdrahtungsplatine (11) gemäß Anspruch 1 oder 2, bei der der Platinenkörper einen mehrschichtigen Aufbau aufweist, bei dem eine Mehrzahl von Keramikschichten und eine Mehrzahl von Innenelektroden laminiert sind.

8. Ein Verdrahtungsplatinenmodul, das Folgendes aufweist:
die Verdrahtungsplatine (11) gemäß Anspruch 1 oder 2 und
eine Komponente (1), die so auf der Verdrahtungsplatine (11) angebracht ist, dass ein Anschluss (1a) der Komponente (1) die Mehrzahl von Kontaktstellenstücken (13a) elektrisch verbindet.

## Revendications

1. Carte de câblage (11) comprenant :
un corps de carte sur lequel doivent être montés des composants ; et
une pluralité de plages de montage (12, 13, 14) formées sur le corps de carte, au moins une des plages de montage (13) ayant une superficie supérieure à la superficie d'au moins une autre plage de montage (12) et se composant d'une pluralité de pièces de plage adjacentes (13a) qui doivent être électriquement connectées par l'intermédiaire d'une borne (1a) de l'un des composants (1) à monter et qui servent par conséquent de plage de montage pour la borne (1a),
**caractérisée en ce que** le rapport de superficie A/a entre la superficie A la plus grande et la superficie la plus petite a des superficies des pièces de plage (13a) et des plages de montage (12, 14), à l'exception des plages de montage (13) composées d'une pluralité de pièces de plage (13a), est de 3 ou moins.

2. Carte de câblage (11) selon la revendication 1, dans laquelle la pluralité de plages de montage (12, 13, 14) sont placées dans des positions correspondant aux bornes (1a) des composants (1) à monter.

3. Carte de câblage (11) selon la revendication 1 ou 2, dans laquelle au moins une pièce de la pluralité de pièces de plage (13a) qui doivent être électriquement connectées par l'intermédiaire d'une borne (1a) de l'un des composants (1) à monter a une superficie ne faisant pas plus de la moitié de la superficie projetée de la borne (1a) sur la surface de montage (11a) du corps de carte.

4. Carte de câblage (11) selon la revendication 1 ou 2, dans laquelle chaque pièce de la pluralité de pièces de plage (13a) qui doivent être électriquement connectées par l'intermédiaire d'une borne (1a) de l'un des composants (1) à monter a une superficie ne faisant pas plus de la moitié de la superficie projetée de la borne (1) sur la surface de montage du corps de carte.

5. Carte de câblage (11) selon la revendication 1 ou 2, dans laquelle une structure de correction de bombage (16) est placée dans une région de la surface du corps de carte où n'est formée aucune plage de montage (12, 13, 14).

6. Carte de câblage (11) selon la revendication 1 ou 2, dans laquelle le corps de carte est constitué de céramique.

7. Carte de câblage (11) selon la revendication 1 ou 2, dans laquelle le corps de carte présente une structure multicouche dans laquelle sont stratifiées une pluralité de couches céramiques et une pluralité d'électrodes internes.

8. Module de carte de câblage comprenant :
la carte de câblage (11) selon la revendication 1 ou 2 ; et
un composant (1) monté sur la carte de câblage (11) de sorte qu'une borne (1a) du composant (1) connecte électriquement la pluralité de pièces de plage (13a).
